# EUROPEAN PATENT APPLICATION

(11) **EP 2 320 573 A2**
(43) Date of publication of application: **11.05.2011**
(21) Application number: 10013880.9
(22) Date of filing: 22.10.2010
(51) Int. Cl.: H03M 1/70, H03M 1/82

(54) **Method of improving a bit resolution digitization of numeric data**

(30) Priority: 10.11.2009 JP 2009257382
(71) Applicant: Bosch Corporation, Tokyo 150-8360 (JP)
(72) Inventor: Takayanagi, Rika, Higashi-matsuyama-shi Saitama 355-8603 (JP)
(74) Representative: Knapp, Thomas

(57) **Abstract**

Errors of the cycle of PWM signal obtained based on digital data can be suppressed as much as possible without varying greatly according to vehicle speed.

It is determined which of categories a cycle of PWM signal computed and calculated based on an output from a vehicle speed sensor 4 falls into (S102 to S114). When the applicable category is determined, the data are made into signed 16-bit digital data with a resolution that has been determined in advance corresponding to the applicable category (S104, S108, S112, and S116). A fixed duty PWM signal having the cycle corresponding to the digital data is generated and is supplied to a navigation device.

## Description

### Technical Field

The present invention relates to digital data processing of numeric data that change variously, and more particularly to the one that intends to, for example, improve resolution.

### Background Art

In a vehicle apparatus configured to control the vehicle motion electronically, the vehicle speed required for engine controlling or the like is used by converting a signal obtained by a vehicle speed sensor into a signal format, a level, or the like that is suitable for various uses. For example, this type of technique is disclosed in Patent Document 1 (JP-A-2004-245690, pp 4-6, Figs. 1 to 3).

Vehicle speed information is often supplied to, for example, a navigation device, which has been commonly equipped in vehicles in recent years. A signal from a vehicle speed sensor is signalprocessing into a signal format, level, or the like that is required by the navigation device or the like and is then supplied as the vehicle speed information.

For example, specifically, a signal obtained by a vehicle speed sensor is a voltage signal proportional to a vehicle speed. When the signal is to be supplied to a navigation device, the output signal from the vehicle speed sensor is converted into a digital signal for a time and is subjected to the process as described in the following in a vehicle electronic control unit for performing vehicle's motion control. Thereby, the signal is converted into a signal format required by the navigation device and is output.

Specifically, first, there are various vehicle speed signal formats that are required by a navigation device. For example, there is a case where a fixed-duty PWM signal having a repetition period changed according to the vehicle speed. In this case, the duty is fixed at 50%, for example.

In such a case, first, in the electronic control unit, the cycle of a PWM signal to be supplied to the navigation device is calculated by digital computation from the output of the vehicle speed sensor that is obtained as the digital signal as described above, based on a predetermined correlation between the output from the vehicle speed sensor and the cycle of PWM signal supplied to the navigation device.

Next, based on the cycle of PWM signal obtained as the digital value, a PWM signal having that cycle is generated and is output to the navigation device.

However, the following problems arise when the cycle of PWM signal according to the vehicle speed is calculated by digital computation and a PWM signal is generated and output based on the result of the calculation as described above.

First, the cycle of PWM signal calculated based on the output value from the vehicle speed sensor obtained as a digital value is conventionally calculated as a signed 32-bit integer, for example. However, there are cases where a circuit that generates and outputs a PWM signal based on the cycle obtained as a digital value may be required an input of the cycle represented by a smaller number of bits, for example, a signed 16-bit integer, for reasons of circuit configuration or the like.

Now, the variation range of the vehicle speed is assumed to be, for example, from 3 km/h to 150 km/h, and it is assumed that the corresponding range of the cycle for generating the PWM signal needs to be, for example, from about 5 ms to about 3300 ms. When this cycle is represented as a signed 16-bit integer as described above, the maximum numerical value that can be represented by 16 bits is 32767 in decimal notation. Accordingly, the resolution per one bit is about 0.1 ms. In such a circumstance, when the cycle is long, the size of error is small and negligible. However, when the cycle is short, i.e., when the cycle is within 5 ms, the minimum range, a difference of about 0.1 ms, which is the resolution per one bit results in an error of as high as 2%. So, there is a problem that the errors vary according to the vehicle speed.

If the number of bits is not changed from the signed 32-bit integer obtained at the time when the digital computation for the cycle is initially performed, the calculation is possible to a 1 µs range in this case. However, in this case, there is a problem in a portion where the cycle is short; for example, a change of 1 ms corresponds to an actual vehicle speed change of 30 km/h, so the cycle of PWM signal cannot sufficiently cover a very small change of the vehicle speed.

### Disclosure of the Invention

### Problems to be Solved by the Invention

This invention has been accomplished in view of the foregoing circumstances. The invention provides a method of improving a bit resolution in digitization of numeric data in which the errors of the cycle of PWM signal based on digital data do not vary greatly due to the vehicle speed, the method being capable of minimizing the error.

### Means for Solving the Problems

In order to accomplish the foregoing object of the invention, a method of improving a bit resolution in digitization of numeric data that change variously is configured to divide a variation range of the numeric data into a plurality of categories, set a resolution for each of the categories, determine which of the categories the acquired numeric data falls into each time the numeric data is acquired, convert the acquired numeric data to have a predetermined number of bits with the resolution that has been determined for the applicable category in advance, and output the data.

### Advantage of the Invention

According to this invention, the resolution of digital data is changed according to the size of numeric data, that is, the size of the cycle of PWM signal to output the data. Therefore, unlike conventional examples, the invention exhibits the following advantageous effects. The errors after data conversion in comparison to the original value before the data conversion do not vary greatly irrespective of the size of the numeric data, and the error variation is suppressed. Thereby, a highly reliable signal can be obtained.

### Brief Description of Drawings

FIG. 1 is a configuration diagram showing an example of the configuration of a vehicle electronic control unit to which the method of improving a bit resolution in digitization of numeric data according to an embodiment of the invention is applied.
FIG. 2 is a subroutine flow-chart showing a processing procedure of improving a bit resolution in digitization of numeric data according to an embodiment of the invention.

### Explanation of Codes

- 1: Microcomputer
- 2: Analog-Digital Converter
- 3: PWM Signal Generating Circuit
- 4: Vehicle Speed Sensor

### Description of Specific Embodiment

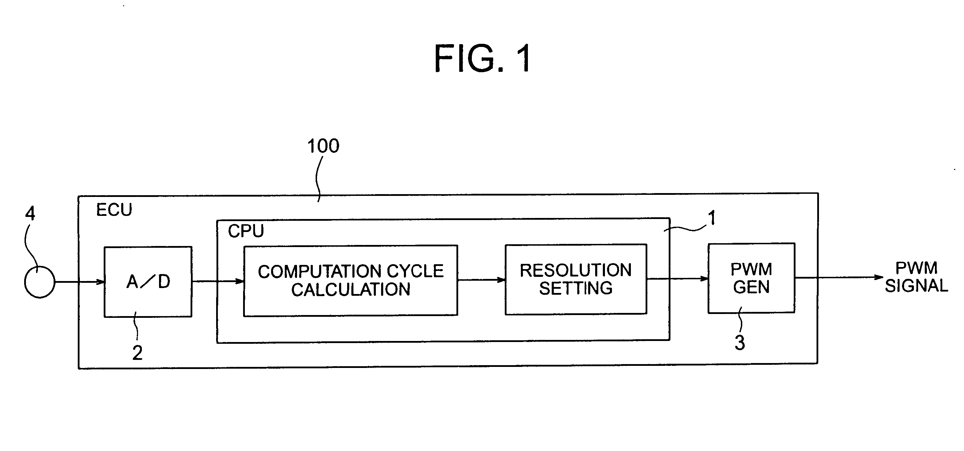

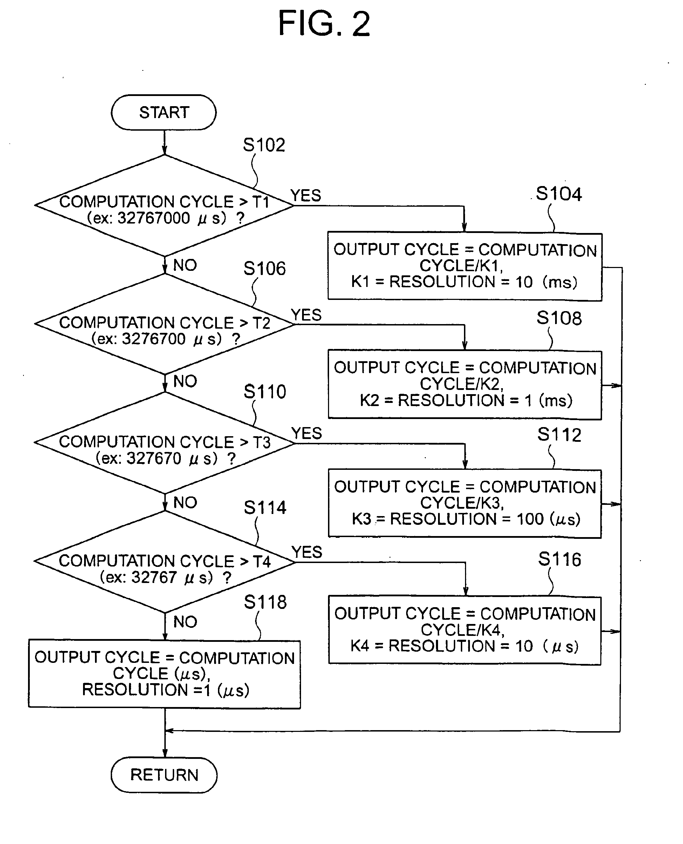

Hereinbelow, embodiments of the invention will be described with reference to Figs. 1 and 2.

It should be noted that the component parts and arrangements that will be described below do not limit the invention, and various modifications thereof are possible within the scope of the invention.

First, an example of the configuration of a vehicle electronic control unit to which the method of improving a bit resolution in digitization of numeric data in an embodiment of the invention is applied will be described with reference to Fig. 1.

A vehicle electronic control unit 100 (which is denoted as "ECU" in Fig. 1) performs, for example, operation control of an engine (not shown) in an electronically controlled vehicle apparatus. However, Fig. 1 shows only the portion relating to the outputting of a variable cycle PWM signal that is output to a navigation device, which is not shown in the drawings.

Such a vehicle electronic control unit 100 has a microcomputer 1 (which is denoted as "CPU" in Fig. 1), which has a publicly and commonly known configuration, an analog-digital converter 2 (which is denoted as "A/D" in Fig. 1), and a PWM signal generating circuit 3 (which is denoted as "PWM GEN" in Fig. 1), as its primary component parts.

An analog input signal from a vehicle speed sensor 4, which is provided at an appropriate location of the vehicle, is input to the analog-digital converter 2 (hereinafter referred to as "A/D converter"). The analog-digital converter 2 converts the analog input signal into a digital signal and outputs to the microcomputer 1.

Here, the signal that is output from the vehicle speed sensor 4 is a voltage signal such that the voltage level rises according to an increase of the vehicle speed.

The microcomputer 1 executes various control processes for motion control of the vehicle, such as engine controlling. In the embodiment of the invention, it performs, as a part of the various control processes, signal processing to the output signal of the vehicle speed sensor 4 as described below. Although the output of the vehicle speed sensor 4 is also used for engine controlling and the like, the following description explains a portion relating to signal processing executed in relation to generation and outputting of a variable cycle PWM signal that is output to a navigation device, which is not shown in the drawings.

First, the output signal of the vehicle speed sensor 4 that is converted into a digital signal by the A/D converter 2 is input to the microcomputer 1, and based on the digital signal, the cycle of the variable cycle PWM signal that is eventually output to the navigation device (not shown) is computed and calculated in a similar manner to conventional examples.

That is, a correlation between the vehicle speed and the cycle of the variable cycle PWM signal that is output to the navigation device (not shown), in other words, a correlation between the output of the vehicle speed sensor 4 and the cycle of the variable cycle PWM signal that is output to the navigation device (not shown), is determined in advance. Using such a correlation, the cycle of the variable cycle PWM signal corresponding to the output of the vehicle speed sensor 4 obtained as a digital value is computed and calculated as described above.

In Fig. 1, such a computation process for the cycle of the variable cycle PWM signal in the microcomputer 1 is denoted as computation cycle calculation." Such a computation cycle calculation is configured to be calculated repeatedly every predetermined time. In the embodiment of the invention, it is calculated as signed 32-bit integer digital data.

In addition, in the microcomputer 1, a bit resolution improving process in digitization of numeric data according to this invention (denoted as "resolution setting" in Fig. 1) is performed (the details will be described later) for the cycle of the variable cycle PWM signal that has been computed and calculated in the above-described manner (hereinafter referred to as "computation cycle"), and the value of the cycle of the variable cycle PWM signal is output as digital data from the microcomputer 1 to the PWM signal generating circuit 3, with a resolution that has been set. In the embodiment of the invention, the output of the computation cycle to the PWM signal generating circuit 3 is performed in the form of signed 16-bit integer digital data.

The PWM signal generating circuit 3 is configured to generate and output a PWM signal with a fixed duty (for example, 50%) as in conventional examples, based on the digital data showing the cycle of the variable cycle PWM signal obtained by the microcomputer 1 as described above. The output signal of such a PWM signal generating circuit 3 is supplied to a navigation device or the like, which is not shown in the drawings.

Fig. 2 shows a subroutine flow-chart illustrating the procedure of the bit resolution improving process in digitization of numeric data that is executed in the microcomputer 1. With reference to this figure, the details of the process will be described below.

First, this series of processes is performed for the computation cycle obtained by the computation cycle calculation process in the microcomputer 1 like conventional examples as explained above. Here, the computation cycle is numeric data that changes variously according to the vehicle speed, and it is obtained as, for example, signed 32-bit integer digital data as described above.

As a precondition, it is assumed that the speed variation range of the vehicle is, for example, from 3 km/h to 150 km/h in the embodiment of the invention, and for that, it is assumed that the range of the cycle of the variable cycle PWM signal that is required by the navigation device, not shown in the drawings, is from 5 ms to 3200 ms.

It is also assumed that the cycle of the variable cycle PWM signal that is output from the microcomputer 1 to the PWM signal generating circuit 3 is output in the form of digital data of signed 16-bit integer.

Then, when a bit resolution setting process for the cycle of the variable cycle PWM signal is started by the microcomputer 1, it is first determined whether or not the computation cycle obtained latest is greater than a first predetermined cycle T1 (see step S102 in Fig. 2).

Here, in the embodiment of the invention, the first predetermined cycle T1 is set to be the maximum value of signed 16-bit integer, 32767 (ms) = 32767000 (µs) in decimal notation.

Then, in step S102, if it is determined that the computation cycle obtained latest is greater than the first predetermined cycle T1 (if YES), the process proceeds to the process of step S104, which will be described next. On the other hand, if it is determined that the computation cycle obtained latest is not greater than the first predetermined cycle T1 (if NO), the process proceeds to the process of step S106, which will be described later.

In step S104, the value obtained by dividing the computation cycle obtained latest by a first coefficient K1 is set as the cycle (output cycle) that is output to the navigation device (not shown) as a signed 16-bit integer.

Here, it is preferable that the first coefficient K1 should be determined taking into consideration a resolution that is desired as the computation cycle that is output to the navigation device (not shown) as a signed 16-bit integer. In other words, it is preferable that the resolution should be such that a deviation of the value of the cycle represented as a signed 16-bit integer from the computation cycle is set to a size that satisfies a desired error range.

In the embodiment of the invention, it is determined that first coefficient K1 = 10000 µs = 10 ms. Accordingly, in the cycle range that exceeds the foregoing first predetermined cycle, the resolution 10 ms, in other words, the least significant bit "1," is represented by a signed 16-bit integer as 10 ms.

After the process of step S104 is executed as described above, the series of processes is finished, and the process returns for a time to a main routine which is not shown in the drawings.

On the other hand, in step S106, it is determined whether or not the computation cycle obtained latest is greater than a second predetermined cycle T2.

In the embodiment of the invention, the second predetermined cycle T2 is set to be 1/10 of the first predetermined cycle T1, that is, T2 = 3276700 (µs). It should be noted that the proportion of the second predetermined cycle T2 to the first predetermined cycle, the foregoing "1/10," is merely an example and is not limited thereto. The proportion should be determined as appropriate taking into consideration, for example, what resolutions the entire range should be divided into.

Then, in step S106, if it is determined that the computation cycle obtained latest is greater than the second predetermined cycle T2 (if YES), the process proceeds to the process of step S108, which will be described next. On the other hand, if it is determined that the computation cycle obtained latest is not greater than the second predetermined cycle T2 (if NO), the process proceeds to the process of step S110, which will be described later.

In step S108, the value obtained by dividing the computation cycle obtained latest by a second coefficient K2 is set as the cycle (output cycle) that is output to the navigation device (not shown) as a signed 16-bit integer.

Here, the second coefficient K2 is set to be 1/10 of the foregoing first coefficient K1. In other words, in the embodiment of the invention, it is set that the second coefficient K2 = 1000 µs = 1 ms. Accordingly, in the cycle range that exceeds the foregoing second predetermined cycle T2, the resolution 1 ms, in other words, the least significant bit "1," is represented by a signed 16-bit integer as 1 ms.

After the process of step S108 is executed as described above, the series of processes is finished, and the process returns for a time to the main routine which is not shown in the drawings.

On the other hand, in step S110, it is determined whether or not the computation cycle obtained latest is greater than a third predetermined cycle T3.

In the embodiment of the invention, the third predetermined cycle T3 is set to be 1/10 of the second predetermined cycle T2, that is, T3 = 327670 (µS).

Then, in step S110, if it is determined that the computation cycle obtained latest is greater than the third predetermined cycle T3 (if YES), the process proceeds to the process of step S112, which will be described next. On the other hand, if it is determined that the computation cycle obtained latest is not greater than the third predetermined cycle T3 (if NO), the process proceeds to the process of step S114, which will be described later.

In step S112, the value obtained by dividing the computation cycle obtained latest by a third coefficient K3 is set as the cycle (output cycle) that is output to the navigation device (not shown) as a signed 16-bit integer.

Here, the third coefficient K3 is set to be 1/10 of the foregoing second coefficient K2. In other words, in the embodiment of the invention, it is set that the third coefficient K3 = 100 µs. Accordingly, in the cycle range that exceeds the foregoing third predetermined cycle T3, the resolution 100 µs, in other words, the least significant bit "1," is represented by a signed 16-bit integer as 100 µs.

After the process of step S112 is executed as described above, the series of processes is finished, and the process returns for a time to the main routine which is not shown in the drawings.

On the other hand, in step S114, it is determined whether or not the computation cycle obtained latest is greater than a fourth predetermined cycle T4.

In the embodiment of the invention, the fourth predetermined cycle T4 is set to be 1/10 of the third predetermined cycle T3, that is, T4 = 32767 (µs).

Then, in step S114, if it is determined that the computation cycle obtained latest is greater than the fourth predetermined cycle T4 (if YES), the process proceeds to the process of step S116, which is described next. On the other hand, if it is determined that the computation cycle obtained latest is not greater than the fourth predetermined cycle T4 (if NO), the process proceeds to the process of step S118, which will be described later.

In step S116, the value obtained by dividing the computation cycle obtained latest by a fourth coefficient K4 is set as the cycle (output cycle) that is output to the navigation device (not shown) as a signed 16-bit integer.

Here, the fourth coefficient K4 is set to be 1/10 of the foregoing third coefficient K3. In other words, in the embodiment of the invention, it is set that the fourth coefficient K4 = 10 µs. Accordingly, in the cycle range that exceeds the foregoing fourth predetermined cycle T4, the resolution 10 µs., in other words, the least significant bit "1," is represented by a signed 16-bit integer as 10 µs.

After the process of step S116 is executed as described above, the series of processes is finished, and the process returns for a time to the main routine which is not shown in the drawings.

On the other hand, in step 118, the computation cycle obtained latest is represented as a signed 16-bit integer and is output as the output cycle to the navigation device (not shown). The series of the processes is finished, and the process returns for a time to the main routine which is not shown in the drawings.

That is, in this case, the resolution is 1 µs, in other words, the least significant bit "1" is represented by a signed 16-bit integer as 1 µs.

Since the resolutions are set respectively according to the sizes of the cycle as described above, errors are suppressed over the entire range of the cycle used. For example, in the example of the embodiment of the invention, the actually measured values of the errors is within ±0.3%.

In the embodiment of the invention, the cycle is categorized according to its size, and the resolution corresponding to the category is set. However, the invention of this application is not necessarily limited to the cycle, but it can be likewise applied to various data that show great variations.

The resolution can be set according to the size of the data. Therefore, the invention can be applied to, for example, an apparatus that requires data with a small variation of errors irrespective of the variation range of the data, in applications in which data having a large variation range are output in a predetermined number of bits.

## Claims

1. A method of improving a bit resolution in digitization of numeric data that change variously, **characterized by** dividing a variation range of the numeric data into a plurality of categories, setting a resolution for each of the categories, determining which of the categories the acquired numeric data falls into each time the numeric data is acquired, converting the acquired numeric data to have a predetermined number of bits with the resolution that has been determined for the applicable category in advance, and outputting the data.

2. The method of improving a bit resolution in digitization of numeric data as set forth in claim 1, **characterized in that** the resolution is such that a deviation of the data value after digitization from the numeric data before digitization is set to be within a range that satisfies a desired error range.

3. The method of improving a bit resolution in digitization of numeric data as set forth in claim 2, **characterized in that** the numeric data are PWM signal cycles in response to vehicle speed.
